# EUROPÄISCHE PATENTSCHRIFT

(11) **EP 0 594 816 B1**
(45) Veröffentlichungstag und Bekanntmachung des Hinweises auf die Patenterteilung: **17.07.1996**
(21) Anmeldenummer: 93909765.5
(22) Anmeldetag: 08.05.1993
(51) Int. Cl.: B05B 13/02, C23C 14/50

(54) **HALTE- UND ANTRIEBSEINRICHTUNG FÜR SUBSTRATTRÄGER MIT PLANETENBEWEGUNG**
HOLDING AND DRIVING DEVICE FOR SUBSTRATE SUPPORTS WITH PLANETARY MOTION
DISPOSITIF DE MAINTIEN ET D'ENTRAINEMENT POUR DES SUPPORTS DE SUBSTRAT A MOUVEMENT PLANETAIRE

(30) Priorität: 16.05.1992 DE 4216311
(43) Veröffentlichungstag der Anmeldung: 04.05.1994
(73) Patentinhaber: VTD-Vakuumtechnik Dresden GmbH, D-01242 Dresden (DE); HAUZER TECHNO COATING EUROPE BV, NL-5916 PB Venlo (NL)
(72) Erfinder: WESER, Frank, D-8027 Dresden (DE)
(74) Vertreter: Pätzelt, Peter, Dipl.-Ing. Patentanwalt
(86) Internationale Anmeldenummer: DE9300421
(87) Internationale Veröffentlichungsnummer: WO9323176

(56) Entgegenhaltungen:
- DE-A- 3 401 815
- DE-C- 675 593
- US-A- 2 110 755
- US-A- 4 816 133

## Beschreibung

### Technisches Gebiet

Die Erfindung betrifft eine Halte- und Antriebseinrichtung für Substratträger mit Planetenbewegung für den Einsatz in Behandlungs- und Beschichtungseinrichtungen, wie Vakuumbeschichtungseinrichtungen. Diese Einrichtungen dienen dazu, die zu beschichtenden Substrate einerseits innerhalb des Beschichtungsraumes sicher aufzunehmen und zu halten und andererseits diese Substrate in eine bestimmte Bewegung zu versetzen, damit sie ausgehend von der Quelle des Beschichtungsmaterials allseitig gleichmäßig beschichtet werden können. Die Art der Substrate kann dabei sehr vielfältig sein, z.B. Werkzeuge wie Spiralbohrer oder Fräser, die mit einer funktionellen harten verschleißfesten Schicht, bzw. Modeschmuck, Gehäuse von Armbanduhren u.ä., die mit einer dekorativen und verschleißfesten Schicht beschichtet werden sollen.

### Stand der Technik

Nach dem Stand der Technik sind neben Durchlaufanlagen allgemein Chargenanlagen verbreitet, in denen während einer Beschichtungscharge eine Vielzahl von Substraten in gesonderten speziellen Substratträgern angeordnet und meist planetenartig einige Zeit um die Quelle des Beschichtungsmaterials bewegt werden. Beispielsweise gibt die DD-A-267 263 eine Substrathaltevorrichtung an, bei der die unmittelbaren Substrathalter in Halterungen gelagert sind und mit diesen eine einfache Drehbewegung ausführen. Zusätzlich sind an den Substrathalterungen Stützrollen angeordnet, mit denen sich die Substrathalterungen auf feststehenden Stützringen abstützen und bei Drehung der Halterungen abrollen. Dadurch führen die auf der Substrathalterung angeordneten Substrate gegenüber dem zentrischen Verdampfertiegel kontinuierliche Planetenbewegungen aus. In ähnlicher Form sind nach dem Stand der Technik eine vielzahl weiterer Substrathaltevorrichtungen mit kontinuierlicher Planetenbewegung bekannt. Derartige ständig in Bewegung befindliche Substrathalterungen sind aber nicht für alle technologischen Erfordernisse geeignet. Es werden sonst auch zahlreich andere Substrathalterungen eingesetzt. Z.B. ist es möglich, eine schrittweise Planetenbewegung der Substrate zu realisieren. Dabei werden die Substrate bzw. die Substratträger über einen Malteserantrieb schrittweise in Drehung versetzt. In der DE-A-34 01 815 sind am Umfang eines sich drehenden Basisteils um eine Hilfsachse drehbare Substrathalterungen angeordnet, die mittels Betätigungseinrichtungen bei jeder Umdrehung des Basisteils eine selektive Drehung um die Hilfsachse ausführen.

Der Nachteil der bekannten Halte- und Antriebseinrichtung für Substratträger und Substrate besteht darin, daß alle diese Einrichtungen eine einmal konstruktiv festgelegte Bewegungsart aufweisen. Änderungen der Substratbewegung sind nur durch Austausch der Substratträgereinrichtung möglich.

### Darstellung der Erfindung

Der Erfindung liegt die Aufgabe zugrunde eine Halt- und Antriebseinrichtung für Substratträger mit Planetenbewegung für den Einsatz in Behandlungs- oder Beschichtungseinrichtungen wie Vakuumbeschichtungseinrichtungen zu schaffen, die wahlweise eine kontinuierliche oder schrittweise Planetenbewegung der Substratträger gestattet.

Die Aufgabe wird durch die im kennzeichnenden Teil des ersten Anspruches angegebenen Mittel gelöst. Bei der erfindungsgemäßen Einrichtung ist eine Grundplatte im Sinne einer zentralen Aufnahme innerhalb der Beschichtungseinrichtung fest angeordnet und der Drehantrieb mit einer Mitnehmerscheibe bewegt sich koaxial zu dieser. Ohne zusätzliche weitere Halterungen sind sowohl ein Zahnkranz wie ein Planetenträger frei auf dem Drehantrieb gelagert. Sie stehen entweder still oder bewegen sich aufgrund der vorhandenen Lagerreibung. Für den systematischen Antrieb der Planeten mit den Substraten gibt es zwei verschiedene Möglichkeiten. Wenn eine kontinuierliche Planetenbewegung der Planeten erforderlich ist, dann wird durch den Einsatz von bekannten Arretierungsmitteln, z.B. Bolzen oder Schrauben, der Zahnkranz mit der Grundplatte und gleichzeitig die Mitnehmerscheibe mit dem Planetenträger verbunden. Dadurch steht der Zahnkranz fest und der Planetenträger führt zwangsweise eine Drehbewegung aus. Dadurch rollt das Ritzel, welches fest mit dem drehbar im Planetenträger gelagerten Planeten verbunden ist, zwangsweise an dem Zahnkranz ab. Die Planeten mit den Substraten führen eine Planetenbewegung aus.

Wenn aus technologischen Gründen eine schrittweise Planetenbewegung der Substrate erforderlich ist, dann wird lediglich der Zahnkranz mit der Mitnehmerscheibe verbunden. Grundsätzlich drehen sich dadurch die Planeten mit den Substraten am Ort, praktisch bewegt sich der Planetenträger aufgrund der Reibung ohne Antrieb um den Drehantrieb bis ein oder mehrere Mitnehmerbolzen, die am radialen Rand oder an anderer geeigneter Stelle am Planetenträger angebracht sind, an ein Schaltelement anstoßen. An dieser Stelle wird der Planetenträger gehalten während die Planeten sich um ihre Achse bewegen, bis durch Bedienereingriff das Schaltelement vom Mitnehmerbolzen ausgeklinkt wird. Danach wird der Planetenträger wieder, durch die Reibung am Drehantrieb und die Antriebskräfte über den Zahnkranz auf das Ritzel, in Drehbewegung gesetzt, bis ein Mitnehmerbolzen erneut an das Schaltelement anschlägt.

Als vorteilhaft hat es sich erwiesen, wenn die axiale Lagerung des Zahnkranzes auf der Grundplatte und des Planetenträgers auf dem Zahnkranz über Axialkugellager erfolgt. Gleitlagerungen sind insbesondere beim Einsatz im Vakuum relativ ungeeignet. Statt der angeführten Arretierungsmittel, die jeweils manuell durch Bohrungen in den einzelnen Elementen eingesteckt bzw. eingeschraubt werden, können auch andere Elemente wie Sperriegel, die z.B. über Federmechanismen von außen betätigt werden können, derart in einzelne Baulementen angeordnet werden, daß sie wahlweise mit den Nachbarelementen in formschlüssigen Kontakt gebracht werden können. Für die radiale Lagerung der Elemente Grundplatte, Zahnkranz und Planetenträger gegenüber dem Drehantrieb ist es ausreichend, einfache Gleitlager anzuordnen. Die Schaltelemente, an die wahlweise die Mitnehmerbolzen anschlagen, können in beliebiger Weise ausgestaltet sein. In einfachster Weise kann es sich um von Hand betätigte Anschlagriegel handeln oder es werden automatisierte, z.B. elektromagnetisch betätigte Schaltelemente gewählt.

Der Vorteil der erfindungsgemäßen Lösung besteht insbesondere darin, daß bei relativ geringen Investitionskosten für den Substratträger die technologischen Möglichkeiten für die Bewegung der Substrate mit einer Einrichtung wesentlich erhöht werden. Der Aufwand zum Umrüsten auf die zwei verschiedenen Bewegungsarten ist gering und die Handhabung sehr einfach. Die Zuverlässigkeit der Gesamteinrichtung hat sich als sehr hoch erwiesen.

In einem Ausführungsbeispiel soll die Erfindung näher dargestellt werden. Die zugehörige Zeichnung zeigt einen Halbschnitt durch eine erfindungsgemäße Halte- und Antriebseinrichtung für Substratträger.

Die Einrichtung befindet sich innerhalb einer Vakuumbeschichtungskammer, in der auch wahlweise die Beschichtungsquellen zentrisch zu den Planeten oder auch radial außerhalb angeordnet sind. Das Basiselement der Einrichtung ist die Grundplatte 1, die fest innerhalb der Vakuumkammer montiert ist. Zentrisch in der Grundplatte 1 befindet sich der Drehantrieb 2. Zur Stabilisierung des Drehantriebes 2 befindet sich zwischen beiden ein einfaches Gleitlager. Oberhalb der Grundplatte 1 ist koaxial zum Drehantrieb 2 ebenfalls zu diesem gleitgelagert ein Zahnkranz 3 angeordnet, der sich über ein Axialkugellager auf der Grundplatte 1 abstützt. Oberhalb des Zahnkranzes 3, diesen radial überlappend, befindet sich eine Mitnehmerscheibe 5, die fest mit dem Drehantrieb 2 verbunden ist. Danach folgt abschließend, ebenfalls radial auf dem Drehantrieb 2 gelagert, der Planetenträger 4, der sich seinerseits über ein Axialkugellager auf dem Zahnkranz 3 abstützt. Der Planetenträger 4 trägt auf einem Teilkreis ein oder mehrere Planeten 6, an dem bzw. denen in bekannter Weise die Substrate 7 gehaltert sind. Erfindungswesentlich ist, daß die drehbar im Planetenträger 4 gelagerten Planeten 6 ein fest mit diesen verbundenes Ritzel 8 aufweisen, welches ständig mit dem Zahnkranz 3 im Eingriff steht. Am äußeren radialen Rand weist der Planetenträger 4 beispielsweise vier Mitnehmerbolzen 11 auf. Unabhängig von der Halte- und Antriebseinrichtung ist ein Schaltelement 10 innerhalb der Vakuumkammer montiert, welches bei Bedarf in die Umlaufbahn der Mitnehmerbolzen 11 eingreifen kann.

Beim Betrieb der Halte- und Antriebseinrichtung für Substratträger besteht Wahlmöglichkeit für zwei verschiedene Bewegungsarten der Planeten 6. Zum einen ist es die kontinuierliche Planetenbewegung und zum anderen ist es die schrittweise Planetenbewegung bei gleichzeitiger kontinuierlicher Eigendrehung der Planeten. Wenn technologisch die kontinuierliche Planetenbewegung der Planeten 6 erforderlich ist, dann werden durch die Arretierungsmittel 9 der Zahnkranz 3 mit der Grundplatte 1 und gleichzeitig der Planetenträger 4 mit der Mitnehmerscheibe 5 verbunden. Als Arretierungsmittel 9 werden einfache Bolzen mit einem Gewindeansatz verwendet, die durch Löcher in den einzelnen Elementen jeweils in die unteren Elemente, hier die Grundplatte 1 und die Mitnehmerscheibe 5, eingeschraubt werden. Wenn der Drehantrieb 2 bei dieser Betriebsart in Bewegung gesetzt wird, dann ist der Zahnkranz 3 feststehend und der Planetenträger dreht sich um den Drehantrieb, damit auch die Planeten 6 und das Ritzel 8 rollt auf den Zahnkranz 3 ab. Die Planeten 6 mit den Substraten 7 führen eine kontinuierliche Planetenbewegung aus. Wenn technologisch die Betriebsart schrittweise Planetenbewegung bei sich kontinuierlich drehenden Planeten 6 erforderlich ist, dann werden die vorher genannten Arretierungsmittel 9 wieder ent fernt und über gleichartige Arretierungsmittel 9 lediglich die Mitnehmerscheibe 5 mit dem Zahnkranz 3 verbunden. Damit dreht sich der Zahnkranz 3 und treibt über das Ritzel 8 die Planeten 6 an. Über die Reibungskräfte wird auch der Planetenträger 4 wieder in Drehung versetzt und die Planeten 6 führen eine echte Planetenbewegung aus. Gleichzeitig wird aber das Schaltelement 10 in die Umlaufbahn der vier Mitnehmerbolzen 4 eingeschaltet. Dadurch kann die beschriebene Drehbewegung des Planetenträgers 4 nur solange fortgesetzt werden, bis ein Mitnehmerbolzen 11 an das Schaltelement 10 anstößt. An dieser Stelle wird der Planetenträger 4 arretiert, und die über das Ritzel 8 angetriebenen Planeten 6 drehen sich stationär um ihre eigene Achse. Je nach der technologisch festgelegten Verweildauer, wird danach das Schaltelement 10 kurz ausgeklinkt. Durch die Reibkräfte des Planetenträgers 4 wird dieser wieder in Drehbewegung versetzt, bis der nächste Mitnehmerbolzen 11 am Schaltelement 10 anstößt.

Mit der beschriebenen erfindungsgemäßen Halte- und Antriebseinrichtung für Substratträger werden die technologischen Anwendungsmöglichkeiten wesentlich erhöht. In bekannter Weise können die Substrate 7 bei kontinuierlicher Planetenbewegung beschichtet werden. Mit geringem Umrüstaufwand kann auch ein stationärer Planetenantrieb mit sich kontinuierlich drehenden Planeten 6 realisiert werden. Dies ist insbesondere dann von Vorteil, wenn die Substrate 7 aufgrund ihrer geometrischen Gestaltung an bestimmten Orten länger beschichtet oder an den einzelnen Stationen von verschiedenen Beschichtungsquellen aus beschichtet werden sollen.

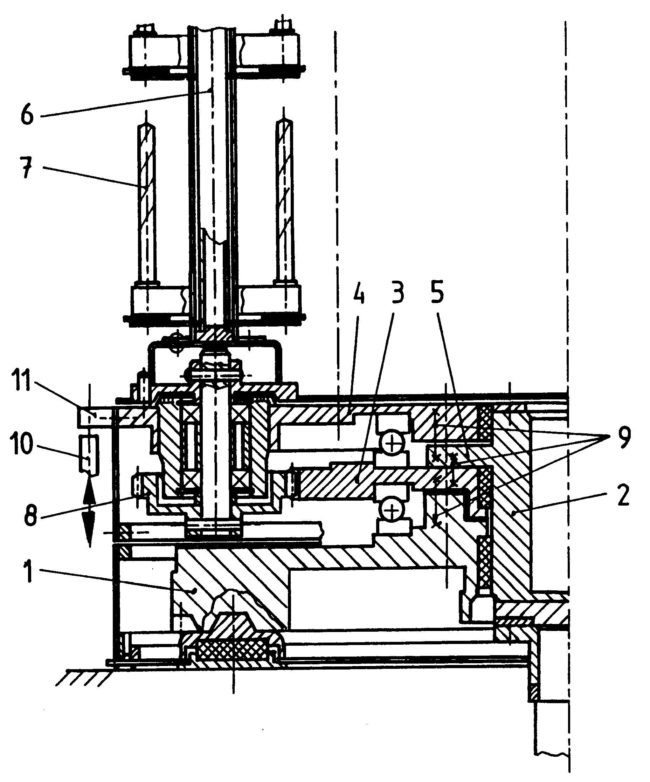

## Patentansprüche

1. Halte- und Antriebseinrichtung für Substratträger mit Planetenbewegung für den Einsatz in Behandlungs- oder Beschichtungseinrichtungen wie Vakuumbeschichtungseinrichtungen, **dadurch gekennzeichnet**, daß zentrisch innerhalb einer feststehenden Grundplatte (1) ein Drehantrieb (2) angeordnet ist, daß die Grundplatte (1) axial gelagert einen Zahnkranz (3) trägt, der drehbar koaxial auf dem Drehantrieb (2) gelagert ist, daß der Zahnkranz (3) axial gelagert einen Planetenträger (4) trägt, der drehbar koaxial auf dem Drehantrieb (2) gelagert ist, daß axial zwischen dem Zahnkranz (3) und dem Planetenträger (4) eine mit dem Drehantrieb (2) fest verbundene Mitnehmerscheibe (5) angeordnet ist, daß in dem Planetenträger (4) auf einem Teilkreis ein oder mehrere Planeten (6) zur Aufnahme der Substrate (7) drehbar gelagert und fest mit einem Ritzel (8) verbunden sind, welches ständig mit dem Zahnkranz (3) im Eingriff steht, und daß zwischen der Grundplatte (1), dem Zahnkranz (3), dem Planetenträger (4) und der Mitnehmerscheibe (5) axial wirksame Arretierungsmittel (9) vorhanden sind, die entweder die Grundplatte (1) mit dem Zahnkranz (3) und den Planetenträger (4) mit der Mitnehmerscheibe (5) oder den Zahnkranz (3) mit der Mitnehmerscheibe (5) verbinden, wobei im letzteren Antriebszustand ein oder mehrere Schaltelemente (10) in die Umlaufbahn eines oder mehrerer Mitnehmerbolzen (11) des Planetenträgers (4) eingreifen.

2. Halte- und Antriebseinrichtung nach Anspruch 1, **dadurch gekennzeichnet**, daß das axiale Lager des Zahnkranzes (3) auf der Grundplatte (1) und das axiale Lager des Planetenträgers (4) auf dem Zahnkranz (3) jeweils ein Axialkugellager ist.

3. Halte- und Antriebseinrichtung nach Anspruch 1, **dadurch gekennzeichnet**, daß die Arretierungsmittel (9) Bolzen sind, die durch Löcher in den jeweils oberen Elementen Zahnkranz (3), Mitnehmerscheibe (5) oder Planetenträger (4) in den jeweils unteren Elementen Grundplatte (1), Zahnkranz (3) oder Mitnehmerscheibe (5) eingesetzt sind.

4. Halte- und Antriebseinrichtung nach Anspruch 1, **dadurch gekennzeichnet**, daß die Arretierungsmittel (9) Sperriegel sind, die in den Elementen Grundplatte (1), Zahnkranz (3), Mitnehmerscheibe (5) oder Planetenträger (4) gelagert sind und durch äußere Betätigungselemente in die jeweiligen Nachbarelemente einrasten.

5. Halte- und Antriebseinrichtung nach Anspruch 1, **dadurch gekennzeichnet**, daß die Elemente Grundplatte (1), Zahnkranz (3) und planetenträger (4) gegenüber dem Drehantrieb (2) radiale Gleitlager aufweisen.

6. Halte- und Antriebseinrichtung nach Anspruch 1, **dadurch gekennzeichnet**, daß das Schaltelement (10) manuell oder mittels automatischer Elemente betätigt wird.

## Claims

1. Holding and driving device for substrate supports with planetary motion for use in treatment or coating devices such as vacuum coating devices, characterised in that a rotary drive (2) is disposed centrally within a fixed base plate (1), that the base plate (1) supports axially mounted a ring gear (3) which is rotatably mounted coaxially on the rotary drive (2), that the ring gear (3) supports axially mounted a planet carrier (4) which is rotatably mounted coaxially on the rotary drive (2), that a driving plate (5) fixedly connected to the rotary drive (2) is disposed axially between the ring gear (3) and the planet carrier (4), that one or a plurality of planets (6) are rotatably mounted in the planet carrier (4) on a partial circle for the purpose of receiving the substrate (7) and are fixedly connected with a pinion (8) which is in permanent engagement with the ring gear (3) and that between the base plate (1), the ring gear (3), the planet carrier (4) and the driving plate (5) are disposed axially effective locking means (9) which connect either the base plate (1) to the ring gear (3) and the planet carrier (4) to the driving plate (5) or the ring gear (3) to the driving plate (5), wherein in the latter drive condition one or a plurality of switching members (10) engage in the circumferential path of one or a plurality of driving pins (11) of the planet carrier (4).

2. Holding and driving device according to claim 1, characterised in that the axial bearing of the ring gear (3) on the base plate (1) and the axial bearing of the planet carrier (4) on the ring gear (3) is in each case an axial ball bearing.

3. Holding and driving device according to claim 1, characterised in that the locking means (9) are pins which are inserted through holes in the respective upper elements, ring gear (3), driving plate (5) or planet carrier (4) into the respective lower elements, base plate (1), ring gear (3) or driving plate (5).

4. Holding and driving device according to claim 1, characterised in that the locking means (9) are locking bars which are mounted in the elements, base plate (1), ring gear (3), driving plate (5) or planet carrier (4) and latch through the outer actuating elements into the respective adjacent elements.

5. Holding and driving device according to claim 1, characterised in that the elements, base plate (1), ring gear (3) and planet carrier (4) comprise radial slide bearings opposite the rotary drive (2).

6. Holding and driving device according to claim 1, characterised in that the switching member (10) is operated manually or by means of automatic elements.

## Revendications

1. Installation de maintien et d'entraînement pour des supports de substrat à mouvement planétaire applicables à des installations de traitement ou enduction telles que des installations d'enduction sous vide, caractérisée en ce qu'au centre à l'intérieur d'une plaque de base (1) fixe, il y a un moyen d'entraînement en rotation (2), la plaque de base (1) portant selon un montage axial, une couronne dentée (3) elle-même montée coaxialement en rotation sur le moyen d'entraînement (2), la couronne dentée (3) portant selon un montage axial un support planétaire (4) monté à rotation, coaxialement sur le moyen d'entraînement (2), et axialement entre la couronne dentée (3) et le support planétaire (4), se trouve un disque d'entraînement (5) relié solidairement au moyen d'entraînement en rotation (2), le support planétaire (4) ayant une ou plusieurs planètes (6) pour recevoir les substrats (7), ces planètes étant réparties sur un cercle primitif, et ces planètes sont reliées solidairement à un pignon (8) en prise en permanence avec la couronne dentée (3) et entre la plaque de base (1), la couronne dentée (3), le support planétaire (4) et le disque d'entraînement (5), il y a des moyens de blocage (9) à effet axial qui relient soit la plaque de base (1) à la couronne dentée (3) et le support planétaire (4) au disque d'entraînement (5), soit la couronne dentée (3) au disque d'entraînement (5), et dans ce dernier état d'entraînement, radialement de l'extérieur un ou plusieurs éléments de commutation (10) peuvent prendre dans la trajectoire radiale périphérique d'un ou plusieurs goujons d'entraînement (11) du support planétaire (4).

2. Installation de maintien et d'entraînement selon la revendication 1, caractérisée en ce que le palier axial de la couronne dentée (3) sur la plaque de base (1) et le palier axial du support planétaire (4) sont montés sur la couronne dentée (3) avec chaque fois un palier axial à billes.

3. Installation de maintien et d'entraînement selon la revendication 1, caractérisée en ce que les moyens de blocage (9) sont des goujons engagés dans des orifices des éléments supérieurs de la couronne dentée (3), du disque d'entraînement (5) ou du support planétaire (4), pour venir dans les éléments de la plaque de base (1) chaque fois en dessous, la couronne dentée (3) et le disque d'entraînement (5).

4. Installation de maintien et d'entraînement selon la revendication 1, caractérisée en ce que les moyens de blocage (9) sont des verrous qui sont montés dans les éléments plaques de base (1), couronnes dentées (3), disques d'entraînement (5) ou supports planétaires (4) et qui s'accrochent dans les éléments voisins respectifs par des éléments de manoeuvre extérieurs.

5. Installation de maintien et d'entraînement selon la revendication 1, caractérisée en ce que les éléments plaques de base (1), couronnes dentées (3), supports planétaires (4) possèdent par rapport au moyen d'entraînement en rotation (2), des paliers glissants radiaux.

6. Installation de maintien et d'entraînement selon la revendication 1, caractérisé en ce que l'élément de commutation (10) est actionné manuellement ou par l'intermédiaire d'éléments automatiques.
